(19) Europäisches Patentamt / European Patent Office / Office européen des brevets

(11) **EP 4 372 786 A1**

(12) **EUROPEAN PATENT APPLICATION**
published in accordance with Art. 153(4) EPC

(43) Date of publication:
**22.05.2024 Bulletin 2024/21**

(21) Application number: **22842430.5**

(22) Date of filing: **12.07.2022**

(51) International Patent Classification (IPC):
**H01L /(2006.01)**

(52) Cooperative Patent Classification (CPC):
**H10N 10/13; H10N 10/17**

(86) International application number:
**PCT/KR2022/010137**

(87) International publication number:
**WO 2023/287168 (19.01.2023 Gazette 2023/03)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **12.07.2021 KR 20210090957**

(71) Applicant: **LG Innotek Co., Ltd.
Seoul 07796 (KR)**

(72) Inventors:
• LEE, Jong Min
  Seoul 07796 (KR)
• LEE, Se Woon
  Seoul 07796 (KR)
• CHOI, Man Hue
  Seoul 07796 (KR)
• LEE, Hyung Eui
  Seoul 07796 (KR)

(74) Representative: **M. Zardi & Co S.A.
Via G. B. Pioda, 6
6900 Lugano (CH)**

(54) **THERMOELECTRIC DEVICE**

(57) A thermoelectric device according to an embodiment of the present invention comprises: a support which includes a first groove and a second groove arranged at one surface thereof to be spaced apart from each other; a thermoelectric module which is disposed on one surface of the support between the first groove and the second groove; and a first sealing member and a second sealing member which are disposed in the first groove and the second groove respectively and are spaced apart from the thermoelectric module.

FIG. 11

EP 4 372 786 A1

## Description

[Technical Field]

The present invention relates to a thermoelectric device, and more specifically, to a thermoelectric device using a temperature difference between a low-temperature part and a high-temperature part of the thermoelectric element.

[Background Art]

A thermoelectric phenomenon is a phenomenon caused by the movement of electrons and holes inside a material and means direct energy conversion between heat and electricity.

A thermoelectric element is a general term for an element using the thermoelectric phenomenon and has a structure in which a P-type thermoelectric material and an N-type thermoelectric material are bonded between metal electrodes to form a PN junction pair.

Thermoelectric elements may be classified into elements using a temperature change in electrical resistance, elements using the Seebeck effect which is a phenomenon in which an electromotive force is generated due to a temperature difference, elements using the Peltier effect which is a phenomenon in which heat absorption or heat generation occurs due to a current, and the like.

Thermoelectric elements are widely applied to home appliances, electronic components, communication components, and the like. For example, the thermoelectric elements may be applied to cooling devices, heating devices, power generation devices, and the like. Therefore, the demand for the thermoelectric performance of the thermoelectric element is gradually increasing.

Recently, there is a need to generate electricity using high-temperature waste heat generated from engines of vehicles, vessels, and the like and the thermoelectric element. In this case, a fluid flow part through which a first fluid passes may be disposed at a low-temperature part side of the thermoelectric element, a heatsink may be disposed at a high-temperature part side of the thermoelectric element, and a second fluid with a higher temperature than the first fluid may pass through the heat sink. Therefore, electricity may be generated by a temperature difference between a low-temperature part and a high-temperature part of the thermoelectric element.

[Disclosure]

[Technical Problem]

The present invention is directed to providing a thermoelectric device using a temperature difference between a low-temperature part and a high-temperature part of a thermoelectric element.

[Technical Solution]

A thermoelectric device according to one embodiment of the present invention includes a support including a first groove and a second groove disposed to be spaced apart from each other in one surface thereof, a thermoelectric module disposed on the one surface between the first groove and the second groove, and a first sealing member and a second sealing member disposed in the first groove and the second groove, respectively, and spaced apart from the thermoelectric module.

The thermoelectric device may further include a shield member disposed on the support, wherein one side of the shield member may be disposed in contact with the first sealing member, and the other side of the shield member may be disposed in contact with the second sealing member.

The thermoelectric module may include a first substrate disposed on the support, a first electrode disposed on the first substrate, a semiconductor structure disposed on the first electrode, a second electrode disposed on the semiconductor structure, a second substrate disposed on the second electrode, and a heat sink disposed on the second substrate, the shield member may include a through hole through which the heat sink is exposed, and an edge of the through hole may be disposed on the second substrate.

The thermoelectric device may further include a thermal interface material layer on the support between the first groove and the second groove, wherein the thermal interface material layer may include a first area disposed to overlap the first substrate between the support and the first substrate, and a second area disposed not to overlap the first substrate at an edge of the first area.

The first groove may be disposed parallel to one side surface of the first substrate, the second groove may be disposed parallel to the other side surface facing the one side surface of the first substrate, the first groove and the one side surface may be spaced apart from each other, and the second groove and the other side surface may be spaced apart from each other.

A ratio of a depth of the first groove to a distance between the one side surface of the first substrate and the first groove may be in a range of 8.75 to 11.42.

A ratio of a width of the first groove to a distance between the one side surface of the first substrate and the first groove may be in a range of 1.84 to 2.5.

A flow path through which a fluid flows may be disposed in the support, and a ratio of a depth of the first groove to a vertical distance between the flow path and a bottom surface of the first groove may be in a range of 0.92 to 1.08.

A ratio of a distance between an edge of the support and the first groove to a depth of the first groove may be 0.61 or more.

A thermoelectric element according to another embodiment of the present invention includes a fluid flow part including one surface and the other surface spaced apart from the one surface in a first direction and including a first groove and a second groove disposed to be spaced apart from each other in the one surface, a plurality of thermoelectric modules disposed on the one surface between the first groove and the second groove, and a first sealing member and a second sealing member disposed in the first groove and the second groove, respectively, and spaced apart from the plurality of thermoelectric modules, wherein the plurality of thermoelectric modules are disposed in a second direction perpendicular to the first direction, and the first groove and the second groove each extend in the second direction and spaced apart from each other in a third direction perpendicular to the first direction and the second direction.

The thermoelectric device may further include a shield member disposed on the one surface, wherein one end of the shield member may be disposed in contact with the first sealing member, and the other end of the shield member may be disposed in contact with the second sealing member.

Each thermoelectric module may include a first substrate disposed on the one surface, a first electrode disposed on the first substrate, a semiconductor structure disposed on the first electrode, a second electrode disposed on the semiconductor structure, a second substrate disposed on the second electrode, and a heat sink disposed on the second substrate, the shield member may include a plurality of through holes through which the heat sink is exposed, and an edge of each through hole may be disposed on the second substrate of each thermoelectric module.

The thermoelectric device may further include a thermal interface material layer disposed on the one surface between the first groove and the second groove.

The first groove may be disposed parallel to one side surface of the first substrate, the second groove may be disposed parallel to the other side surface facing the one side surface of the first substrate, the first groove and the one side surface may be spaced apart from each other, and the second groove and the other side surface may be spaced apart from each other.

[Advantageous Effects]

According to an embodiment of the present invention, it is possible to obtain a thermoelectric device that can have a simple structure, can be easy to assemble, and can accommodate a maximum number of thermoelectric elements in a predetermined space.

According to the embodiment of the present invention, it is possible to obtain a thermoelectric device with high thermoelectric performance by increasing a temperature difference between a high-temperature part and a low-temperature part.

The thermoelectric device according to the embodiment of the present invention can be applied to power generation devices for generating electricity using the temperature difference between the high-temperature part and the low-temperature part.

The thermoelectric device according to an embodiment of the present invention can be applied to a Peltier device for cooling or heating a specific object such as a fluid.

[Description of Drawings]

FIG. 1 is a perspective view of a thermoelectric device according to one embodiment of the present invention.
FIG. 2 is an exploded perspective view of the thermoelectric device according to one embodiment of the present invention.
FIG. 3 is a cross-sectional view of a thermoelectric element according to one embodiment of the present invention.
FIG. 4 is a perspective view of the thermoelectric element according to one embodiment of the present invention.
FIG. 5 is a perspective view of one surface of a fluid flow part included in the thermoelectric device according to one embodiment of the present invention.
FIG. 6 is a top view of a plurality of thermoelectric modules and a guide member disposed on the one surface of a fluid flow part included in the thermoelectric device according to one embodiment of the present invention.
FIG. 7 is a top view of the plurality of thermoelectric modules, the guide member, and a plurality of support members disposed on the one surface of the fluid flow part included in the thermoelectric device according to one embodiment of the present invention.
FIG. 8 is a top view of the plurality of thermoelectric modules, the guide member, the plurality of support members, and a shield member disposed on the one surface of the fluid flow part included in the thermoelectric device according to one embodiment of the present invention.
FIG. 9 is a perspective view of the thermoelectric module included in the thermoelectric device according to one embodiment of the present invention.
FIG. 10 is a top view of a first substrate of the thermoelectric module included in the thermoelectric device according to one embodiment of the present invention.
FIG. 11 is a cross-sectional view of the thermoelectric device according to one embodiment of the present invention.

[Modes of the Invention]

Hereinafter, exemplary embodiments according to the present invention will be described in detail with reference to the accompanying drawings.

However, the technical spirit of the present invention is not limited to some of the described embodiments, but may be implemented in various different forms, and one or more of the components among the embodiments may be used by being selectively coupled or substituted without departing from the scope of the technical spirit of the present invention.

In addition, terms (including technical and scientific terms) used in embodiments of the present invention may be construed as meaning that may be generally understood by those skilled in the art to which the present invention pertains unless explicitly specifically defined and described, and the meanings of the commonly used terms, such as terms defined in a dictionary, may be construed in consideration of contextual meanings of related technologies.

In addition, the terms used in the embodiments of the present invention are for describing the embodiments and are not intended to limit the present invention.

In the specification, a singular form may include a plural form unless otherwise specified in the phrase, and when described as "at least one (or one or more) of A, B, and C," one or more among all possible combinations of A, B, and C may be included.

In addition, terms such as first, second, A, B, (a), and (b) may be used to describe components of the embodiments of the present disclosure.

These terms are only for the purpose of distinguishing one component from another component, and the nature, sequence, order, or the like of the corresponding components is not limited by these terms.

In addition, when a first component is described as being "connected," "coupled," or "joined" to a second component, it may include a case in which the first component is directly connected, coupled, or joined to the second component, but also a case in which the first component is "connected," "coupled," or "joined" to the second component by other components present between the first component and the second component.

In addition, when a certain component is described as being formed or disposed on "on (above)" or "below (under)" another component, the terms "on (above)" or "below (under)" may include not only a case in which two components are in direct contact with each other, but also a case in which one or more other components are formed or disposed between the two components. In addition, when described as "on (above) or below (under)," it may include the meaning of not only an upward direction but also a downward direction based on one component.

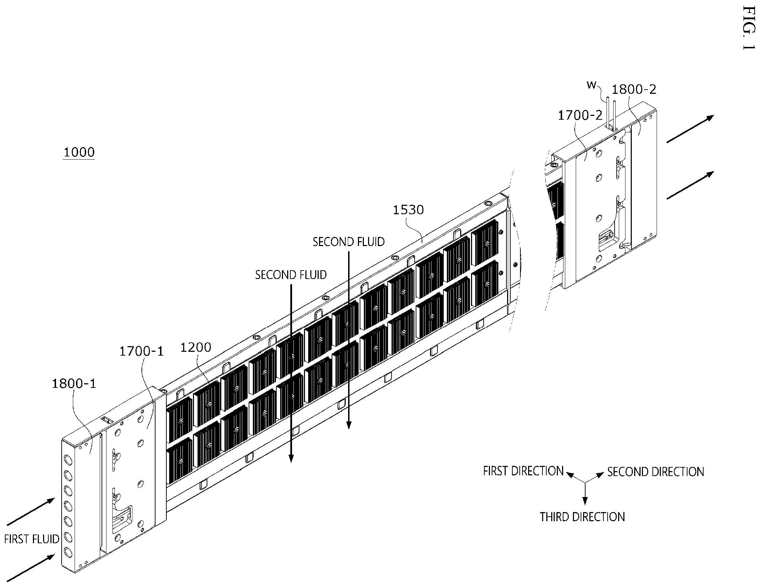

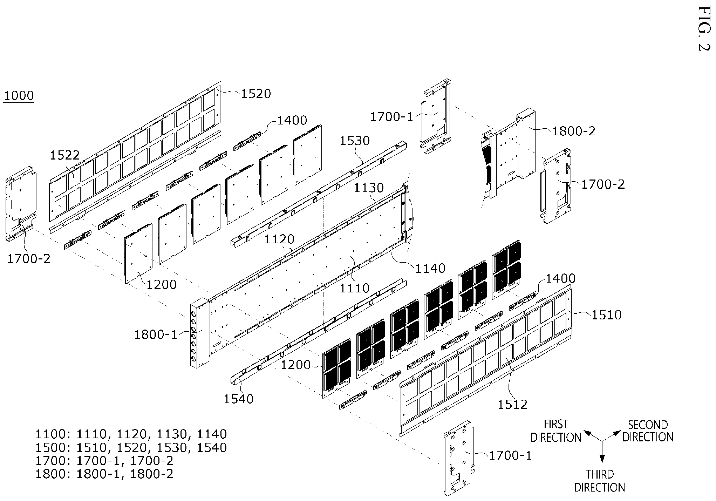

FIG. 1 is a perspective view of a thermoelectric device according to one embodiment of the present invention, and FIG. 2 is an exploded perspective view of the thermoelectric device according to one embodiment of the present invention.

Referring to FIGS. 1 and 2, a thermoelectric device 1000 includes a fluid flow part 1100 and a thermoelectric module 1200 disposed on a surface of the fluid flow part 1100.

The thermoelectric device 1000 according to the embodiment of the present invention may generate power using a temperature difference between a first fluid flowing inside the fluid flow part 1100 and a second fluid flowing outside the fluid flow part 1100. A plurality of thermoelectric devices 1000 may be disposed in parallel to be spaced predetermined distances from each other to form a power generation system.

The first fluid flowing into the fluid flow part 1100 may be water, but is not limited thereto and may be various types of fluids with cooling performance. A temperature of the first fluid flowing into the fluid flow part 1100 may be lower than 100 °C, preferably, lower than 50 °C, and more preferably, lower than 40 °C, but is not limited thereto and may be a fluid with a lower temperature than the second fluid. A temperature of the first fluid discharged after passing through the fluid flow part 1100 may be higher than the temperature of the first fluid flowing into the fluid flow part 1100.

According to the embodiment of the present invention, a plurality of thermoelectric modules 1200 may be disposed on a first surface 1110 and a second surface 1120 facing the first surface 1110 of the fluid flow part 1100. The first fluid may flow from one side surface between the first surface 1110 and the second surface 1120 toward the other side surface facing the one side surface between the first surface 1110 and the second surface 1120. To this end, a fluid inlet may be disposed in the one side surface, and a fluid outlet may be disposed in the other side surface. The second fluid may flow from a third surface 1130, which is an upper surface between the first surface 1110 and the second surface 1120, toward a fourth surface 1140, which is a lower surface between the first surface 1110 and the second surface 1120. For convenience of description, in the specification, a direction from the first surface 1110 to the second surface 1120 may be referred to as a first direction, a direction in which the first fluid flows may be referred to as a second direction, and a direction in which the second fluid flows may be referred to as a third direction, but the present invention is not limited thereto.

In order to facilitate the introduction and discharge of the first fluid and support the fluid flow part 1100, a first connecting member 1800-1 and a second connecting member 1800-2 may be installed at the fluid inlet side and the fluid outlet side of the fluid flow part 1100, respectively. In the specification, the first connecting member 1800-1 and the second connecting member 1800-2 may be used interchangeably with the first tube expanding member 1800-1 and the second tube expanding member 1800-2, respectively. Alternatively, in the specification, the first connecting member 1800-1 and the second connecting member 1800-2 may be used interchangeably with the first tube expanding block 1800-1 and the second tube expanding block 1800-2, respectively.

Meanwhile, the second fluid passes through the outside of the thermoelectric module 1200, for example, a heat sink disposed outside the fluid flow part 1100. The second fluid may have waste heat generated from engines of vehicles, vessels, and the like, but is not limited thereto. For example, a temperature of the second fluid may be 100 °C or higher, preferably, 200 °C or higher, and more preferably, 220 to 250 °C, but is not limited thereto and may be a fluid with a higher temperature than the first fluid.

In the specification, an example in which a temperature of the first fluid flowing through the inside of the fluid flow part 1100 is lower than the temperature of the second fluid passing through the heat sink of the thermoelectric module 1200 disposed outside the fluid flow part 1100 will be described. Therefore, in the specification, the fluid flow part 1100 may be referred to as a duct or a cooling part. However, the embodiment of the present invention is not limited thereto, and the temperature of the first fluid flowing through the inside of the fluid flow part 1100 may be higher than the temperature of the second fluid passing through the heat sink of the thermoelectric module 1200 disposed outside the fluid flow part 1100.

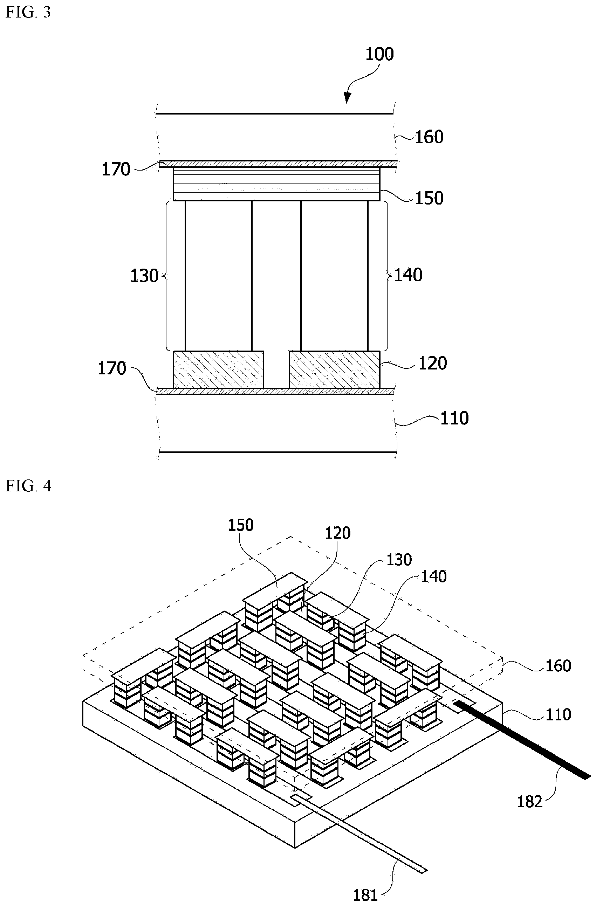

According to the embodiment of the present invention, the thermoelectric module 1200 includes a thermoelectric element and the heat sink disposed on the thermoelectric element. The thermoelectric element according to the embodiment of the present invention may have a structure of a thermoelectric element 100 illustrated in FIGS. 3 and 4.

Referring to FIGS. 3 and 4, the thermoelectric element 100 includes a first substrate 110, a first electrode 120, a P-type thermoelectric leg 130, an N-type thermoelectric leg 140, a second electrode 150, and a second substrate 160.

The first electrode 120 is disposed between the first substrate 110 and lower bottom surfaces of the P-type thermoelectric leg 130 and the N-type thermoelectric leg 140, and the second electrode 150 is disposed between the second substrate 160 and upper bottom surfaces of the P-type thermoelectric leg 130 and the N-type thermoelectric leg 140. Therefore, the plurality of P-type thermoelectric legs 130 and the plurality of N-type thermoelectric legs 140 are electrically connected by the first electrodes 120 and the second electrodes 150. A pair of P-type thermoelectric legs 130 and N-type thermoelectric legs 140 disposed between the first electrode 120 and the second electrode 150 and electrically connected may form a unit cell.

For example, when a voltage is applied to the first electrode 120 and the second electrode 150 through lead wires 181 and 182, due to the Peltier effect, a substrate in which a current flows from the P-type thermoelectric leg 130 to the N-type thermoelectric leg 140 may absorb heat to function as a cooling part, and a substrate in which a current flows from the N-type thermoelectric leg 140 to the P-type thermoelectric leg 130 may be heated to function as a heating part. Alternatively, when the temperature difference between the first electrode 120 and the second electrode 150 is applied, charges in the P-type thermoelectric leg 130 and the N-type thermoelectric leg 140 may be moved due to the Seebeck effect to generate electricity.

Here, the P-type thermoelectric leg 130 and the N-type thermoelectric leg 140 may be bismuth telluride (Bi-Te)-based thermoelectric legs containing bismuth (Bi) and tellurium (Te) as main raw materials. The P-type thermoelectric leg 130 may be a bismuth telluride (Bi-Te)-based thermoelectric leg containing at least one of antimony (Sb), nickel (Ni), aluminum (Al), copper (Cu), silver (Ag), lead (Pb), boron (B), gallium (Ga), tellurium (Te), bismuth (Bi), and indium (In). For example, the P-type thermoelectric leg 130 may contain Bi-Sb-Te, which is the main raw material, at 99 to 99.999 wt% based on 100 wt% of the total weight and contain at least one of nickel (Ni), aluminum (Al), copper (Cu), silver (Ag), lead (Pb), boron (B), gallium (Ga), and indium (In) at 0.001 to 1 wt%. The N-type thermoelectric leg 140 may be a bismuth telluride (Bi-Te)-based thermoelectric leg containing at least one of selenium (Se)), nickel (Ni), aluminum (Al), copper (Cu), silver (Ag), lead (Pb), boron (B), gallium (Ga), tellurium (Te), bismuth (Bi), and indium (In). For example, the N-type thermoelectric leg 140 may contain Bi-Se-Te, which is the main raw material, at 99 to 99.999 wt% based on 100 wt% of the total weight and contain at least one of nickel (Ni), aluminum (Al), copper (Cu), silver (Ag), lead (Pb), boron (B), gallium (Ga), and indium (In) at 0.001 to 1 wt%.

The P-type thermoelectric leg 130 and the N-type thermoelectric leg 140 may be formed in a bulk type or a stack type. In general, the bulk-type P-type thermoelectric leg 130 or the bulk-type N-type thermoelectric leg 140 may be obtained through a process of manufacturing an ingot through thermal treatment for a thermoelectric material, crushing and sieving the ingot to acquire powder for the thermoelectric leg, then sintering the powder, and cutting a sintered body. In this case, the P-type thermoelectric leg 130 and the N-type thermoelectric leg 140 may be polycrystalline thermoelectric legs. As described above, when the P-type thermoelectric leg 130 and the N-type thermoelectric leg 140 are the polycrystalline thermoelectric legs, strengths of the P-type thermoelectric leg 130 and the N-type thermoelectric leg 140 may be increased. The stack-type P-type thermoelectric leg 130 or the stack-type N-type thermoelectric leg 140 may be obtained through a process of coating a sheet-shaped base with a paste containing a thermoelectric material to form a unit member, and then stacking and cutting the unit members.

In this case, the pair of P-type thermoelectric legs 130 and N-type thermoelectric legs 140 may have the same shape and volume or have different shapes and volumes. For example, since the electrical conduction characteristics of the P-type thermoelectric leg 130 and the N-type thermoelectric leg 140 are different, a height or cross-sectional area of the N-type thermoelectric leg 140 may be formed differently from a height or cross-sectional area of the P-type thermoelectric leg 130.

In this case, the P-type thermoelectric leg 130 or the N-type thermoelectric leg 140 may have a cylindrical shape, a polygonal pillar shape, an oval pillar shape, or the like.

In the specification, the thermoelectric leg may be referred to as a thermoelectric structure, a semiconductor element, a semiconductor structure, or the like.

The performance of the thermoelectric element according to one embodiment of the present invention may be expressed as a thermoelectric figure of merit (ZT). The ZT can be expressed as in Equation 1.

[Equation 1]

$$ZT = \alpha^2 \cdot \sigma \cdot T/k$$

Here, $\alpha$ denotes a Seebeck coefficient [V/K], $\sigma$ denotes an electrical conductivity [S/m], and $\alpha^2\sigma$ denotes a power factor [W/mK$^2$]. In addition, T denotes a temperature, and k denotes a thermal conductivity [W/mK]. k can be expressed as $a \cdot cp \cdot \rho$, in which a denotes a thermal diffusivity [cm$^2$/S], cp denotes a specific heat [J/gK], and $\rho$ denotes a density [g/cm$^3$].

In order to obtain a thermoelectric performance index of the thermoelectric element, a Z value (V/K) may be measured using a Z meter, and the ZT may be calculated using the measured Z value.

Here, the first electrode 120 disposed between the first substrate 110 and the P-type thermoelectric leg 130 and the N-type thermoelectric leg 140, and the second electrode 150 disposed between the second substrate 160 and the P-type thermoelectric leg 130 and the N-type thermoelectric leg 140 may contain at least one of copper (Cu), silver (Ag), aluminum (Al), and nickel (Ni) and have a thickness of 0.01 to 0.3 mm. When a thickness of the first electrode 120 or the second electrode 150 is smaller than 0.01 mm, a function as an electrode may be degraded, thereby reducing the electrical conduction performance, and when the thickness exceeds 0.3 mm, the electrical conduction efficiency can be reduced due to an increase in resistance.

In addition, the first substrate 110 and the second substrate 160 facing each other may be metal substrates, and thicknesses thereof may be in a range of 0.1 to 1.5 mm. When the thickness of the metal substrate is smaller than 0.1 mm or more than 1.5 mm, the heat radiation characteristics or thermal conductivity may be excessively high, thereby reducing the reliability of the thermoelectric element. In addition, when the first substrate 110 and the second substrate 160 are metal substrates, an insulating layer 170 may be further formed between the first substrate 110 and the first electrode 120 and between the second substrate 160 and the second electrode 150. The insulating layer 170 may contain a material with a thermal conductivity of 1 to 20 W/mK. In this case, the insulating layer 170 may be a layer made of a resin composition containing at least one of an epoxy resin and silicone resin and an inorganic material, a silicone composite containing silicone and an inorganic material, or an aluminum oxide layer. Here, the inorganic material may be at least one of an oxide, a nitride, and a carbide combined with aluminum, boron, silicon, and the like.

In this case, the first substrate 110 and the second substrate 160 may be formed to have different sizes. In other words, a volume, thickness, or area of one of the first substrate 110 and the second substrate 160 may be formed to be greater than a volume, thickness, or area of the other one. Here, the thickness may be a thickness in a direction from the first substrate 110 to the second substrate 160, and the area may be an area in a direction perpendicular to a direction from the first substrate 110 to the second substrate 160. Therefore, it is possible to enhance the heat absorption or heat radiation performance of the thermoelectric element. Preferably, the volume, thickness, or area of the first substrate 110 may be formed to be greater than at least one of the volume, thickness, or area of the second substrate 160. In this case, when the first substrate 110 is disposed in a high-temperature area for the Seebeck effect, when the first substrate 110 is applied as a heating area for the Peltier effect, or when a sealing member for protecting the first substrate 110 from an external environment of the thermoelectric element, which will be described below, is disposed on the first substrate 110, at least one of the volume, the thickness, and the area of the first substrate may become greater than the second substrate 160. In this case, the area of the first substrate 110 may be in a range of 1.2 to 5 times the area of the second substrate 160. When the area of the first substrate 110 is formed to be smaller than 1.2 times that of the second substrate 160, the influence on improving thermal transfer efficiency is not high, and when the area of the first substrate 110 exceeds 5 times, the thermal transfer efficiency may be rather reduced significantly, thereby making it difficult to maintain a basic shape of the thermoelectric module.

In addition, a heat radiation pattern, for example, an uneven pattern may be formed on a surface of at least one of the first substrate 110 and the second substrate 160. Therefore, it is possible to enhance the heat radiation performance of the thermoelectric element. When the uneven pattern is formed on the surface in contact with the P-type thermoelectric leg 130 or the N-type thermoelectric leg 140, it is possible to improve the bonding characteristics between the thermoelectric leg and the substrate.

Although not illustrated, a sealing member may be further disposed between the first substrate 110 and the second substrate 160. The sealing member may be disposed on side surfaces of the first electrode 120, the P-type thermoelectric leg 130, the N-type thermoelectric leg 140, and the second electrode 150 between the first substrate 110 and the second substrate 160. Therefore, the first electrode 120, the P-type thermoelectric leg 130, the N-type thermoelectric leg 140, and the second electrode 150 may be shielded from external moisture, heat, contamination, and the like.

Referring back to FIGS. 1 and 2, the plurality of thermoelectric modules 1200 may be disposed on the first surface 1110 and the second surface 1120 of the fluid flow part 1100.

As described above, each thermoelectric element includes the first substrate 110 disposed in contact with the fluid flow part 1100, the plurality of first electrodes 120 disposed on the first substrate 110, the plurality of thermoelectric legs 130 and 140 disposed on the plurality of first electrodes 120, the plurality of second electrodes 150 disposed on the plurality of thermoelectric legs 130 and 140, and the plurality of second electrodes 150, and the heat sink is disposed on the second substrate 160. In this case, the first substrate of the thermoelectric element disposed on the fluid flow part 1100 may be a metal substrate, and the metal substrate may be attached to the surface of the fluid flow part 1100 by a thermal interface material (TIM) (not illustrated). Since the metal substrate has excellent thermal transfer performance, thermal transfer between the thermoelectric element and the fluid flow part 1100 is easy. In addition, when the metal substrate and the fluid flow part 1100 are bonded by the TIM, the thermal transfer between the metal substrate and the fluid flow part 1100 may not be hindered. Here, the metal substrate may be one of a copper substrate, an aluminum substrate, and a copper-aluminum substrate, but is not limited thereto.

Each of the plurality of thermoelectric modules 1200 may include a connector part for extracting generated electricity to the outside or applying the electricity to be used as a Peltier device. According to the embodiment of the present invention, a support member 1400 may be disposed around the connector part to uniformly maintain a bonding strength between the thermoelectric module 1200 and the fluid flow part 1100 and protect a wire connected to the connector part.

In addition, according to the embodiment of the present invention, a shield member 1500 may be further disposed to prevent moisture or contaminants from flowing into the plurality of thermoelectric modules 1200. The shield member 1500 may include a first shield member 1510 disposed on the first surface 1110 of the fluid flow part 1100 and a second shield member 1520 disposed on the second surface 1120 of the fluid flow part 1100. The first shield member 1510 and the second shield member 1520 may each be disposed on the second substrate of the thermoelectric element. In this case, in order for the second fluid to pass through the heat sink, through holes 1512 and 1522 may be formed in the first shield member 1510 and the second shield member 1520, respectively, and edges of the through holes 1512 and 1522 may be disposed in the second substrate of the thermoelectric element so that the heat sink may be exposed through the through holes 1512 and 1522. Therefore, it is possible to protect the inside of the thermoelectric element from external contaminants, moisture, and the second fluid and allow the second fluid to directly pass through the heat sink, thereby efficiently performing the heat exchange between the second fluid and the heat sink. According to one embodiment of the present invention, the shield member 1500 may further include a third shield member 1530 disposed on the third surface 1130 of the fluid flow part 1100 and a fourth shield member 1540 disposed at the fourth surface 1140 of the fluid flow part 1100. Since the second fluid may flow in a direction from the third surface 1130 to the fourth surface 1140 of the fluid flow part 1100, an insulating member may be further disposed between the third surface 1130 of the fluid flow part 1100 and the third shield member 1530 and between the fourth surface 1140 and the fourth shield member 1540. Therefore, since the first fluid flowing inside the fluid flow part 1100 and the second fluid flowing outside the fluid flow part 1100 are insulated, it is possible to enhance the thermoelectric performance of the thermoelectric element.

Meanwhile, according to the embodiment of the present invention, a guide member 1700 may be further disposed on the first surface 1110 and the second surface 1120 of the fluid flow part 1100. The guide member 1700 may function to guide the wire connected to the thermoelectric module 1200 to the outside. The guide member 1700 may be disposed on a side surface of the thermoelectric module 1200 on each of the first surface 1110 and the second surface 1120 of the fluid flow part 1100.

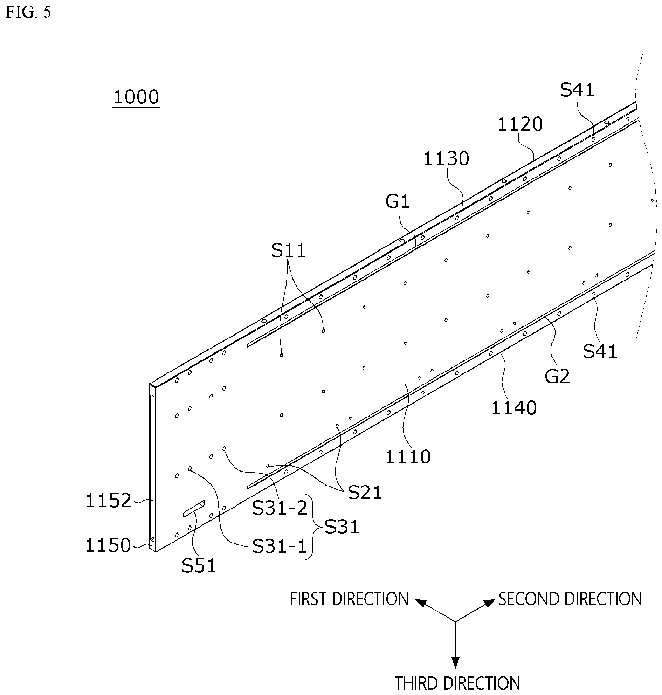

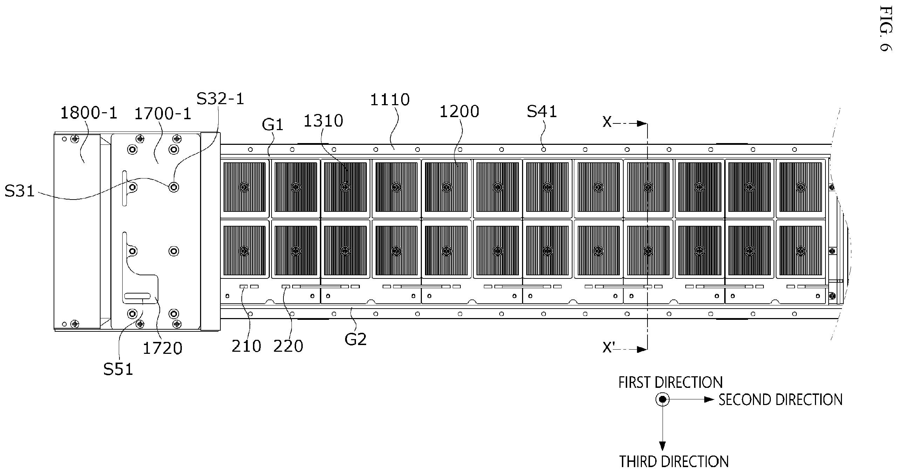

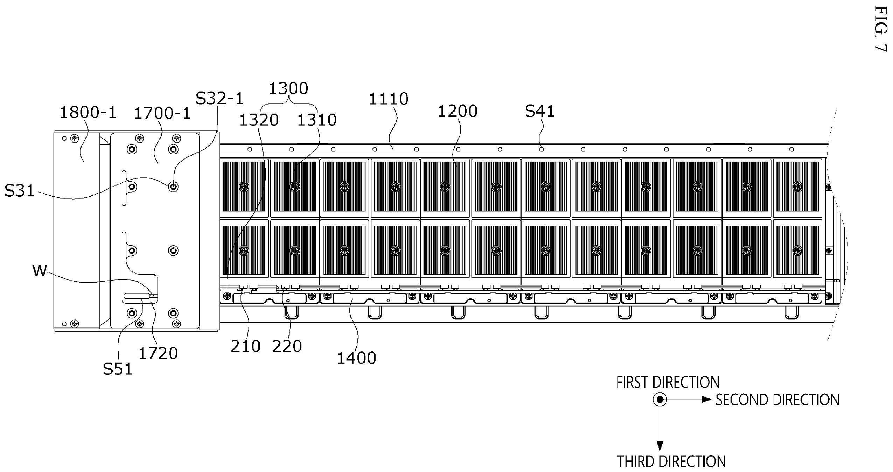

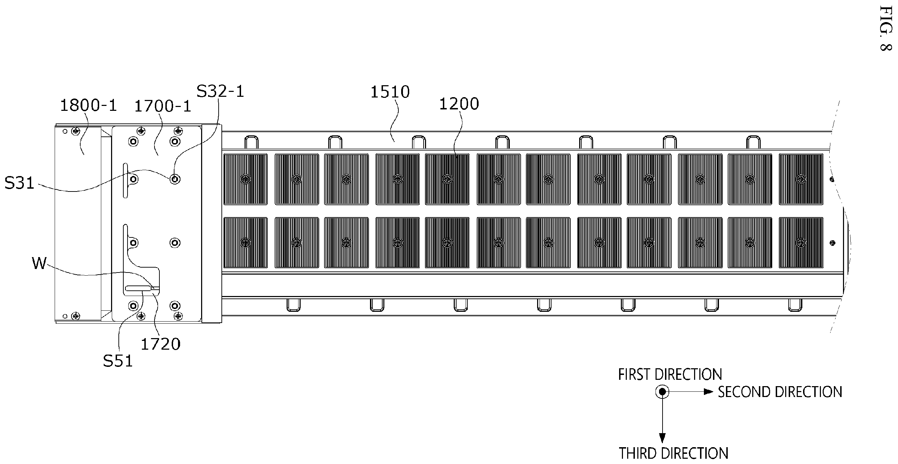

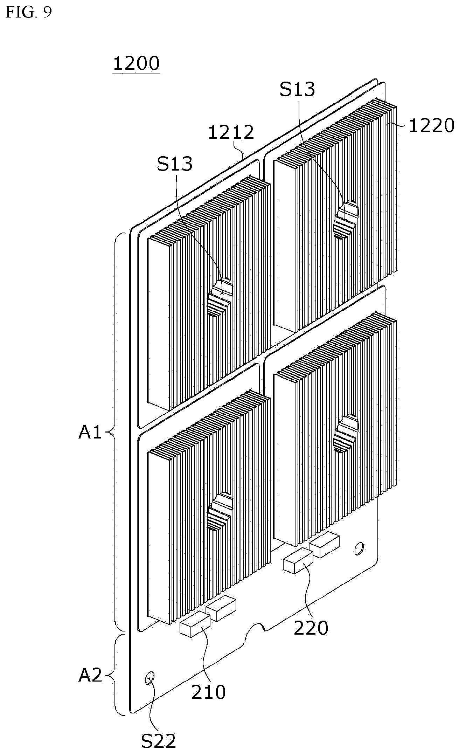

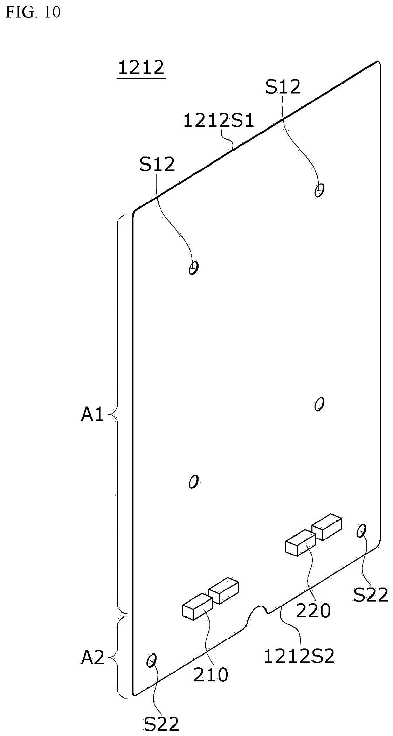

FIG. 5 is a perspective view of one surface of a fluid flow part included in the thermoelectric device according to one embodiment of the present invention, FIG. 6 is a top view of a plurality of thermoelectric modules and a guide member disposed on the one surface of the fluid flow part included in the thermoelectric device according to one embodiment of the present invention, FIG. 7 is a top view of the plurality of thermoelectric modules, the guide member, and a plurality of support members disposed on the one surface of the fluid flow part included in the thermoelectric device according to one embodiment of the present invention, FIG. 8 is a top view of the plurality of thermoelectric modules, the guide member, the plurality of support members, and a shield member disposed on the one surface of the fluid flow part included in the thermoelectric device according to one embodiment of the present invention, FIG. 9 is a perspective view of the thermoelectric module included in the thermoelectric device according to one embodiment of the present invention, and FIG. 10 is a top view of a first substrate of the thermoelectric module included in the thermoelectric device according to one embodiment of the present invention.

Referring to FIGS. 5 to 10, the thermoelectric module 1200 and a guide member 1700-1 are disposed on the first surface 1100 of the fluid flow part 1100. Hereinafter, for convenience of description, only the thermoelectric module 1200 and the guide member 1700-1 disposed on the first surface 1110 of the fluid flow part 1100 are described, but the present invention is not limited thereto, and the same structure may be applied to the second surface 1120, which is a surface opposite to the first surface 1110. With regard to the fluid flow part 1100 and the thermoelectric module 1200, overlapping descriptions of the same contents as those described with reference to FIGS. 1 to 4 will be omitted.

According to the embodiment of the present invention, a first substrate 1212 of the thermoelectric module 1200 is disposed on the first surface 1110 of the fluid flow part 1100. In this case, the first substrate 1212 may be disposed in direct contact with the first surface 1110 of the fluid flow part 1100 or disposed in indirect contact therewith through the TIM or the like. The first substrate 1212 may be the first substrate 110 described with reference to FIGS. 1 to 4. Therefore, with regard to the first substrate 1212, overlapping descriptions of the same contents as the first substrate 110 described with reference to FIGS. 1 to 4 will be omitted.

As illustrated in FIGS. 9 and 10, the first substrate 1212 of the thermoelectric module 1200 may include a first area A1 and a second area A2. In this case, a plurality of first electrodes, a plurality of thermoelectric legs, a plurality of second electrodes, a second substrate, and a heat sink 1220 may be disposed in the first area A1, and connector parts 210 and 220 connected to the first electrode may be disposed in the second area A2, which is one side of the first area A1. Here, the plurality of first electrodes, the plurality of thermoelectric legs, the plurality of second electrodes, and the second substrate may be the plurality of first electrodes 120, the plurality of thermoelectric legs 130 and 140, the plurality of second electrodes 150, and the second substrate 160 described with reference to FIGS. 1 to 4. In FIG. 9, an example in which the second substrate and the heat sink 1220 are divided into four portions is illustrated, but the present invention is not limited thereto. One second substrate and one heat sink 1220 may be disposed for one first substrate, or the second substrate and the heat sink 1220 may be divided into two or more for one first substrate.

According to the embodiment of the present invention, as illustrated in FIGS. 6 to 8, the fluid flow part 1100 and the thermoelectric module 1200 may be coupled by a coupling member 1300. To this end, a first groove S11 formed to overlap the first substrate 1212 of the thermoelectric module 1200 in the first direction, that is, a direction from the first surface 1110 to the second surface 1120 may be formed in the first surface 1110 of the fluid flow part 1100 (see FIG. 5), and a through hole S12 corresponding to the first groove S11 may be formed in the first area A1 of the first substrate 1212 of the thermoelectric module 1200. In addition, a through hole S13 corresponding to the first groove S11 and the through hole S12 may also be formed in the second substrate (not illustrated) and the heat sink 1220 of the thermoelectric module 1200. Therefore, as illustrated in FIGS. 6 to 8, a first coupling member 1310 is coupled to the first groove S11, the through hole S12, and the through hole S13, and thus the fluid flow part 1100 and the thermoelectric module 1200 may be coupled.

Meanwhile, according to the embodiment of the present invention, a second groove S21 may be further formed in the first surface 1110 of the fluid flow part 1100 (see FIG. 5), and a through hole S22 corresponding to the second groove S21 may be further formed in the second area A2 of the first substrate 1212 of the thermoelectric module 1200. In addition, a support member 1400 may be further disposed in the second area A2 of the first substrate 1212, and as illustrated in FIG. 7, the support member 1400 may be connected to the second groove S21 and the through hole S22 through a second coupling member 1320, and thus the fluid flow part 1100, the thermoelectric module 1200, and the support member 1400 may be fixed.

Therefore, since not only the first area A1 but also the second area A2 of the first substrate 1212 of the thermoelectric module 1200 may be coupled to the fluid flow part 1100, the entirety of the first substrate 1212 of the thermoelectric module 1200 may have uniform bonding strength with the fluid flow part 1100, and heat may be uniformly distributed to the entirety of the first substrate 1212. In particular, as illustrated in FIG. 7, when the first substrate 1212 of the thermoelectric module 1200 and the fluid flow part 1100 are coupled using the support member 1400, it is possible to increase a fastening torque of the second coupling member 1320 due to the application of the support member 1400. Therefore, since there is a low possibility that the second coupling member 1320 becomes loose even under a vibration condition, the thermoelectric module 1200 may be more firmly attached to the fluid flow part 1100.

Meanwhile, referring to FIG. 5, the fluid flow part 1100 may have a fluid inlet 1152 of the fluid flow part 1100 disposed in one side surface 1150 between the first surface 1110 and the second surface 1120 and a fluid outlet of the fluid flow part 1100 disposed in the other side surface between the first surface 1110 and the second surface 1120.

In addition, referring to FIGS. 5 to 8, according to the embodiment of the present invention, holes S31 and S41 may be formed in the first surface 1110 of the fluid flow part 1100 so as not to overlap the thermoelectric module 1200. The holes S31 and S41 may be formed to pass through the fluid flow part 1100 from the first surface 1110 to the second surface 1120 of the fluid flow part 1100. For example, the hole S31 may be a hole through which the guide member 1700-1 is fastened, and the hole S41 may be a hole through which the shield member 1500 is fastened. According to the embodiment of the present invention, the TIM may be disposed between the fluid flow part 1100 and the thermoelectric module 1200 in order to maximize the thermal transfer performance between the fluid flow part 1100 and the thermoelectric module 1200. In contrast, the guide member 1700-1 or the shield member 1500 may be disposed on the fluid flow part 1100 without the TIM and then fastened using the coupling member. Therefore, the holes S31 and S41 through which the guide member 1700-1 or the shield member 1500 is fastened may be formed to pass through the first surface 1110 and the second surface 1120 of the fluid flow part 1100.

According to the embodiment of the present invention, a hole S51 may be further formed in the first surface 1110 of the fluid flow part 1100 so as not to overlap the thermoelectric module 1200. The hole S51 may be formed to pass through the fluid flow part 1100 from the first surface 1110 to the second surface 1120 of the fluid flow part 1100 and may be a hole through which the wire connected to the thermoelectric module 1200 passes. To this end, the hole S51 may have a greater area than other holes S31 and S41 have, and the hole S51 may be disposed in a range parallel to the second area A2 of the second substrate 1212 of the thermoelectric module 1200. Therefore, the wires connected to the connector parts 210 and 220 and supported by the support member 1400 may be disposed to extend to the hole S51, and the wire electrically connected to the thermoelectric module 1200 may pass through the hole S51 and be electrically connected to the thermoelectric module 1200 of the second surface 1120.

According to the embodiment of the present invention, the holes S51 may be symmetrically disposed in the one side surface 1150 and the other side surface of the fluid flow part 1100, and a wire W may pass through the hole S51 in the one side surface 1150 and the hole S51 in the other side surface.

Meanwhile, referring to FIGS. 1, 2, and 6 to 9, the thermoelectric device 1000 includes the fluid flow part 1100 and the thermoelectric module 1200 disposed on the surface of the fluid flow part 1100. The thermoelectric module 1200 may include a thermoelectric element 1210 and a heat sink 1220 disposed on the thermoelectric element 1210. According to the embodiment of the present invention, the guide member 1700 may be disposed on the side surfaces of the plurality of thermoelectric modules 1200. When a direction in which the plurality of thermoelectric modules 1200 are disposed is referred to as a second direction, the guide member 1700 may be disposed in the second direction with respect to the plurality of thermoelectric modules 1200.

For example, a pair of guide members 1700-1 and 1700-2 may be disposed to face each other at one sides of the first surface 1110 and the second surface 1120 of the fluid flow part 1100. In addition, the pair of guide members 1700-1 and 1700-2 may also be disposed to face each other at the other sides of the first surface 1110 and the second surface 1120 of the fluid flow part 1100.

For example, the first fluid may flow into the one sides of the first surface 1110 and the second surface 1120 of the fluid flow part 1100, and the first fluid may be discharged from the other sides of the first surface 1110 and the second surface 1120 of the fluid flow part 1100.

When the first guide member 1700-1 is disposed on the side surface of the thermoelectric module 1200 at the one side of the first surface 1110 of the fluid flow part 1100, the second guide member 1700-2 may be disposed to face the first guide member 1700-1 on the side surface of the thermoelectric module 1200 with the fluid flow part 1100 interposed therebetween at the one side of the second surface 1120 of the fluid flow part 1100. Likewise, when the second guide member 1700-2 is disposed on the side surface of the thermoelectric module 1200 at the other side of the first surface 1110 of the fluid flow part 1100, the first guide member 1700-1 may be disposed to face the second guide member 1700-2 on the side surface of the thermoelectric module 1200 with the fluid flow part 1100 interposed therebetween at the other side of the second surface 1120 of the fluid flow part 1100.

According to the embodiment of the present invention, the guide member 1700 is disposed on the side surface of the thermoelectric module 1200 to reduce an empty space and guide the wire connected to the thermoelectric module 1200. Here, the guide member 1700 may be a structure that does not function as the thermoelectric element. Therefore, in the specification, the guide member may be referred to as a dummy module, a dummy member, or a guide module. Therefore, it is possible to minimize the empty space in the side surface of the thermoelectric module 1200 on the fluid flow part 1100, thereby reducing the possibility of moisture or the second fluid flowing into the empty space.

Meanwhile, referring to FIG. 7, the support member 1400 may be disposed adjacent to the connector parts 210 and 220 on the first substrate 1212 of the thermoelectric module 1200, and the wires W connected to the connector parts 210 and 220 may extend to the guide member 1700-1 in the second direction through the support member 1400. Therefore, the support member 1400 may uniformly maintain the bonding strength between the thermoelectric module 1200 and the fluid flow part 1100 and protect the wires connected to the connector parts 210 and 220.

Referring back to FIGS. 5 to 8, the first surface 1110 of the fluid flow part 1100 includes a first groove G1 and a second groove G2 disposed to be spaced apart from each other, and the thermoelectric module 1200 is disposed between the first groove G1 and the second groove G2. The plurality of thermoelectric modules 1200 may be disposed in the second direction, the first groove G1 and the second groove G2 may each extend in the second direction, and the first groove G1 and the second groove G2 may be spaced apart from each other in the third direction perpendicular to the second direction. In this case, the first groove G1 may be disposed parallel to one side surfaces of the first substrates 1212 of the plurality of thermoelectric modules 1200, the second groove G2 may be disposed parallel to the other side surfaces facing the one side surfaces of the first substrates 1212, the first groove G1 may be disposed to be spaced apart from the one side surfaces of the first substrates 1212, and the second groove G2 may be disposed to be spaced apart from the other side surfaces of the first substrates 1212. In this case, one of the one side surface and the other side of the first substrate 1212 may be a side at which the connector parts 210 and 220 and the support member 1400 are disposed. Therefore, it is easy to align the plurality of thermoelectric modules 1200 between the first groove G1 and the second groove G2.

Hereinafter, the relationship between the first groove G1 and the second groove G2 included in the fluid flow part 1100 and the thermoelectric module 1200 in the thermoelectric device according to one embodiment of the present invention will be described in more detail.

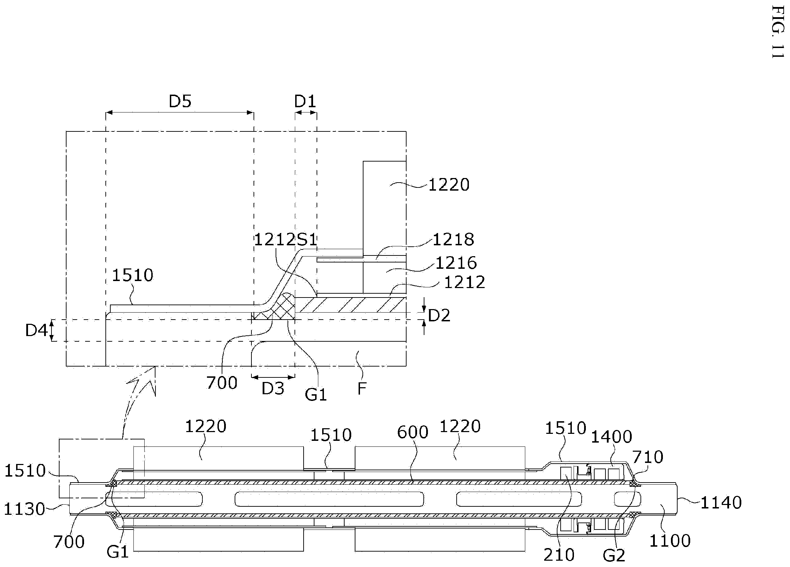

FIG. 11 is a cross-sectional view of the thermoelectric device according to one embodiment of the present invention. FIG. 11 is a cross-sectional view along line X-X' in FIG. 6. Overlapping descriptions of the contents that are the same as those described with reference to FIGS. 1 to 10 will be omitted.

Referring to FIG. 11, the first surface 1110 of the fluid flow part 1100 includes the first groove G1 and the second groove G2 disposed to be spaced apart from each other, and the thermoelectric modules 1200 are disposed between the first groove G1 and the second groove G2. As described above, the thermoelectric module 1200 may include the thermoelectric element 1210 and the heat sink 1220 disposed on the thermoelectric element 1210, the first substrate 1212 of the thermoelectric element 1210 may be disposed on the first surface 1110 of the fluid flow part 1100, a first electrode (not illustrated), a semiconductor element 1216, a second electrode (not illustrated), and a second substrate 1218 may be disposed sequentially, and the heat sink 1220 may be disposed on the second substrate 1218. Here, the descriptions of the first substrate 110, the first electrode 120, the thermoelectric legs 130 and 140, the second electrode 150, and the second substrate 160, which are described with reference to FIGS. 3 and 4, may be applied to the first substrate 1212, the first electrode (not illustrated), the semiconductor element 1216, the second electrode (not illustrated), and the second substrate 1218.

According to the embodiment of the present invention, the first groove G1 may be spaced apart from and disposed parallel to one side surface 1212S1 of the first substrate 1212 of the thermoelectric element 1210 between the one side surface 1212S of the first substrate 1212 of the thermoelectric element 1210 and the third surface 1130 of the fluid flow part 1100. Likewise, the second groove G2 may be spaced apart from and disposed parallel to the other side surface 1212S2 of the first substrate 1212 of the thermoelectric element 1210 between the other side surface 1212S2 of the first substrate 1212 of the thermoelectric element 1210 and the fourth surface 1140 of the fluid flow part 1100. Here, the other side surface 1212S2 of the first substrate 1212 may be a surface disposed to face the one side surface 1212S1 of the first substrate 1212, and the other side 1212S2 of the first substrate 1212 may have connector parts 210 and 2200 and the support member 1400 may be disposed at the other surface 1212S2 side of the first substrate 1212. The plurality of thermoelectric modules 1200 may be disposed by being aligned side by side between the first groove G1 and the second groove G2. In addition, since a jig for coating a portion between the first surface 1110 of the fluid flow part 1100 and the first substrate 1212 of the thermoelectric element 1210 with a thermal interface material layer 600 may be installed in the first groove G1 and the second groove G2, the first surface 1110 between the first groove G1 and the second groove G2 may be coated with the thermal interface material layer 600 having a uniform thickness.

According to the embodiment of the present invention, the thermal interface material layer 600 may be disposed between the first groove G1 and the second groove G2 on the first surface 1110 of the fluid flow part 1100. In this case, the thermal interface material layer 600 may include a first area disposed to vertically overlap the first substrate 1212 and a second area disposed not to overlap the first substrate 1212 at an edge of the first area between the first surface 1110 of the fluid flow part 1100 and the first substrate 1212. Therefore, since a front surface of the first substrate 1212 is bonded to the first surface 1110 of the fluid flow part 1100 with the thermal interface material layer 600 interposed therebetween, it is possible to achieve uniform bonding strength and thermal interface efficiency between the first substrate 1212 and the first surface 1110 of the fluid flow part 1100 on a front surface of the first substrate 1212 and also maintain high bonding strength and thermal interface efficiency at an edge of the first substrate 1212.

According to the embodiment of the present invention, a first shield member 1510 may be disposed on the first surface 1110 of the fluid flow part 1100. In this case, the first shield member 1510 may be disposed on the second substrate 1218 of the thermoelectric element 1210, and in order for the second fluid to pass through the heat sink 1220, a through hole may be formed in the first shield member 1510, and an edge of the through hole may be disposed in the second substrate 1218 of the thermoelectric element 1210 so that the heat sink may be exposed through the through hole. Therefore, it is possible to protect the inside of the thermoelectric element from external contaminants, moisture, and second fluid and allow the second fluid to directly pass through the heat sink, thereby efficiently performing the heat exchange between the second fluid and the heat sink. In the specification, since the fluid flow part 1100 supports the thermoelectric module 1200, the fluid flow part 1100 may be used interchangeably with a support or metal support.

According to the embodiment of the present invention, a first sealing member 700 may be disposed in the first groove G1 along the first groove G1, a second sealing member 710 may be disposed in the second groove G2 along the second groove G2, one side of the first shield member 1510 may be disposed in contact with the first sealing member 700, and the other side of the first shield member 1510 may be disposed in contact with the second sealing member 710. The first sealing member 700 and the second sealing member 710 may include at least one of epoxy resin and silicone resin. Here, the one side of the first shield member 1510 may be disposed close to the third surface 1130 of the fluid flow part 1100, and the other side of the second shield member 1510 may be disposed close to the fourth surface 1140 of the fluid flow part 1100. Therefore, the first sealing member 700 and the second sealing member 710 may function to make airtightness between the one side of the first shield member 1510 and the first surface 1110 of the fluid flow part 1100 and between the other side of the first shield member 1510 and the first surface 1110 of the fluid flow part 1100. Therefore, it is possible to protect the inside of the thermoelectric element from external contaminants, moisture, and the second fluid.

Although not illustrated in FIG. 11, one end of the first shield member 1510 may be disposed in the first groove G1, the other end of the second shield member 1520 may be disposed in the second groove G2, the first sealing member 700 may be disposed in the first groove G1 and at the one end of the first shield member 1510, and the second sealing member 710 may be disposed in the second groove G2 and at the other end of the first shield member 1510.

Although not illustrated in FIG. 11, the one end of the first shield member 1510 may be disposed to be fitted into the first groove G1, the other end of the second shield member 1520 may be disposed to be fitted into the second groove G2, the first sealing member 700 may be disposed around the first groove G1 and the one end of the first shield member 1510, and the second sealing member 710 may be disposed around the second groove G2 and the other end of the first shield member 1510.

According to the embodiment of the present invention, a ratio (D2/D1) of a depth D2 of the first groove G1 to a distance D1 between the one side surface 1212S1 of the first substrate 1212 and the first groove G1 may be in a range of 8.75 to 11.42. Therefore, the first groove G1 can be sufficiently coated with the first sealing member 700 to make airtightness between the fluid flow part 1100 and the one side of the first shield member 1510, the possibility of the first sealing member 700 coming into contact with the first substrate 1212 of the thermoelectric element 1210 can be minimized, and the influence on the electrical performance of the thermoelectric element 1210 can be reduced.

According to the embodiment of the present invention, a ratio (D3/D1) of a width D3 of the first groove G1 to the distance D1 between the one side surface 1212S1 of the first substrate 1212 and the first groove G1 may be in a range of 1.84 to 2.5. Therefore, it is possible to make airtightness between the fluid flow part 1100 and the one side of the first shield member 1510 by a contact area between the first sealing member 700 disposed in the first groove G1 and the one side of the first shield member 1510, the possibility of the first sealing member 700 coming into contact with the first substrate 1212 of the thermoelectric element 1210 can be minimized, the influence on the electrical performance of the thermoelectric element 1210 can be reduced, and the one end of the first shield member 1510 can be accommodated in the first groove G1.

Meanwhile, according to the embodiment of the present invention, a flow path F through which a fluid flows may be disposed in the fluid flow part 1100. In this case, a ratio (D2/D4) of a depth D2 of the first groove G1 to a distance D4 between the flow path F and a bottom surface of the first groove G1 may be in a range of 0.92 to 1.08. Therefore, since the first groove G1 is sufficiently coated with the first sealing member 700 to make the airtightness between the fluid flow part 1100 and the one side of the first shield member 1510 and the flow path F is disposed close to the first surface 1110 of the fluid flow part 1100, it is possible to maintain high thermal interface performance between the fluid in the flow path F and the first surface 1110 of the fluid flow part 1100.

According to the embodiment of the present invention, a ratio (D5/D2) of a distance D5 between the edge of the fluid flow part 1100 and the first groove G1 to the depth D2 of the first groove G1 may be 0.61 or more. In this case, the distance D5 between the edge of the fluid flow part 1100 and the first groove G1 may be 10 mm or more. Therefore, it is easy to process the first groove G1 and reduce the possibility of the first sealing member 700 flowing to the third surface 1130 of the fluid flow part 1100.

As described above, although only the numerical range related to the first groove G1 has been described for convenience of description, the same description can also be applied to the numerical range related to the second groove G2.

However, according to the embodiment of the present invention, the distance between the one side surface 1212S1 of the first substrate 1212 and the first groove G1 may differ from the distance between the other side surface 1212S2 of the first substrate 1212 and the second groove G2. For example, the distance between the other side surface 1212S2 of the first substrate 1212 and the second groove G2 may be greater than the distance between the one side surface 1212S1 of the first substrate 1212 and the first groove G1. For example, the distance between the other side surface 1212S2 of the first substrate 1212 and the second groove G2 may be 1.5 mm or more. As described above, the connector parts 210 and 220 and the support member 1400 may be disposed on the other side surface 1212S2 of the first substrate 1212. When the distance between the other side surface 1212S2 of the first substrate 1212 and the second groove G2 satisfies these requirements, the possibility of a wire W disposed on the connector parts 210 and 220 or the support member 1400 coming into contact with the second sealing member 710 can be minimized.

As described above, although the description has been made focusing on the thermoelectric module 1200 and the first/second grooves G1 and G2 disposed on the first surface 1110 of the fluid flow part 1100, the same description can also be applied to the second surface 1120 of the fluid flow part 1100.

Throughout the specification, although the thermoelectric elements 100 and 1210 are described as including the first substrate 110, the first electrode 120, the P-type thermoelectric leg 130, the N-type thermoelectric leg 140, the second electrode 150, and the second substrate 160, the definition of the thermoelectric elements 100 and 1210 is not limited thereto, and the thermoelectric elements 100 and 1210 may include the first electrode 120, the P-type thermoelectric leg 130, the N-type thermoelectric leg 140, the second electrode 150, and the second substrate 160 and mean as being disposed on the first substrate 110.

The power generation system may generate power through heat sources generated from vessels, vehicles, power plants, geothermal heat, or the like and include a plurality of power generation devices arranged to efficiently converge the heat sources. In this case, in each power generation device, it is possible to improve the cooling performance of the low-temperature part of the thermoelectric element by improving the bonding strength between the thermoelectric module and the fluid flow part, thereby improving the efficiency and reliability of the power generation device and thus improving the fuel efficiency of the transportation such as vessels or vehicles. Therefore, in the shipping and transportation industry, it is possible to reduce transportation costs, create an eco-friendly industry environment, and reduce material costs and the like when applied to a manufacturing industry such as a steel mill.

Although the present invention has been described above with reference to exemplary embodiments, those skilled in the art will understand that the present invention may be modified and changed variously without departing from the spirit and scope of the present invention as described in the appended claims.

## Claims

1. A thermoelectric device comprising:

   a support including a first groove and a second groove disposed to be spaced apart from each other in one surface thereof;
   a thermoelectric module disposed on the one surface between the first groove and the second groove; and
   a first sealing member and a second sealing member disposed in the first groove and the second groove, respectively, and spaced apart from the thermoelectric module.

2. The thermoelectric device of claim 1, further comprising a shield member disposed on the support, wherein one side of the shield member is disposed in contact with the first sealing member, and the other side of the shield member is disposed in contact with the second sealing member.

3. The thermoelectric device of claim 2, wherein the thermoelectric module includes a first substrate disposed on the support, a first electrode disposed on the first substrate, a semiconductor structure disposed on the first electrode, a second electrode disposed on the semiconductor structure, a second substrate disposed on the second electrode, and a heat sink disposed on the second substrate,

   the shield member includes a through hole through which the heat sink is exposed, and an edge of the through hole is disposed on the second substrate.

4. The thermoelectric device of claim 3, further comprising a thermal interface material layer on the support between the first groove and the second groove, wherein the thermal interface material layer includes a first area disposed to overlap the first substrate between the support and the first substrate, and a second area disposed not to overlap the first substrate at an edge of the first area.

5. The thermoelectric device of claim 3, wherein the first groove is disposed parallel to one side surface of the first substrate, the second groove is disposed parallel to the other side surface facing the one side surface of the first substrate, the first groove and the one side surface are spaced apart from each other, and the second groove and the other side surface are spaced apart from each other.

6. The thermoelectric device of claim 5, wherein a ratio of a depth of the first groove to a distance between the one side surface of the first substrate and the first groove is in a range of 8.75 to 11.42.

7. The thermoelectric device of claim 5, wherein a ratio of a width of the first groove to a distance between the one side surface of the first substrate and the first groove is in a range of 1.84 to 2.5.

8. The thermoelectric device of claim 5, wherein a flow path through which a fluid flows is disposed in the support, and
   a ratio of a depth of the first groove to a vertical distance between the flow path and a bottom surface of the first groove is in a range of 0.92 to 1.08.

9. The thermoelectric device of claim 4, wherein a ratio of a distance between an edge of the support and the first groove to a depth of the first groove is 0.61 or more.

10. A thermoelectric device comprising:

a fluid flow part including one surface and the other surface spaced apart from the one surface in a first direction and including a first groove and a second groove disposed to be spaced apart from each other in the one surface;

a plurality of thermoelectric modules disposed on the one surface between the first groove and the second groove; and

a first sealing member and a second sealing member disposed in the first groove and the second groove, respectively, and spaced apart from the plurality of thermoelectric modules,

wherein the plurality of thermoelectric modules are disposed in a second direction perpendicular to the first direction, and

the first groove and the second groove each extend in the second direction and spaced apart from each other in a third direction perpendicular to the first direction and the second direction.

FIG. 1

FIG. 2

1100: 1110, 1120, 1130, 1140
1500: 1510, 1520, 1530, 1540
1700: 1700-1, 1700-2
1800: 1800-1, 1800-2

FIG. 3

FIG. 4

FIG. 5

1000

S41

1120

1130

G1

S11

S41

G2

1140

1110

1152

1150

S21

S31-2

S31-1

S31

S51

FIRST DIRECTION

SECOND DIRECTION

THIRD DIRECTION

FIG. 6

FIG. 7

FIG. 8

EP 4 372 786 A1

20

FIRST DIRECTION

SECOND DIRECTION

THIRD DIRECTION

FIG. 9

1200

S13

1212

1220

S13

A1

A2

S22

210

220

FIG. 10

FIG. 11

# EP 4 372 786 A1

| | INTERNATIONAL SEARCH REPORT | International application No. |
|---|---|---|
| | | **PCT/KR2022/010137** |

**A. CLASSIFICATION OF SUBJECT MATTER**

**H01L 35/32**(2006.01)i; **H01L 35/30**(2006.01)i

According to International Patent Classification (IPC) or to both national classification and IPC

**B. FIELDS SEARCHED**

Minimum documentation searched (classification system followed by classification symbols)

H01L 35/32(2006.01); G04G 19/00(2006.01); H01L 35/04(2006.01); H01L 35/28(2006.01); H01L 35/34(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 열전소자(thermoelectric element), 홈(groove), 실링(sealing), 실드(shield), 유체유동부(fluid flow path), 관통홀(through hole)

**C. DOCUMENTS CONSIDERED TO BE RELEVANT**

| Category* | Citation of document, with indication, where appropriate, of the relevant passages | Relevant to claim No. |
|---|---|---|
| Y | KR 10-2019-0042198 A (LG INNOTEK CO., LTD.) 24 April 2019 (2019-04-24)<br>See claims 1 and 5. | 1-2 |
| A | | 3-10 |
| Y | KR 10-2020-0029874 A (LG INNOTEK CO., LTD.) 19 March 2020 (2020-03-19)<br>See paragraphs [0096]-[0098]; claims 7, 9 and 11; and figures 1 and 11. | 1-2 |
| A | KR 10-2016-0047843 A (SAMSUNG ELECTRONICS CO., LTD.) 03 May 2016 (2016-05-03)<br>See claims 1-3; and figure 2. | 1-10 |
| A | KR 10-1716559 B1 (DENSO CORP.) 14 March 2017 (2017-03-14)<br>See paragraphs [0043]-[0044]; and figure 3. | 1-10 |
| A | KR 10-2021-0017784 A (LG INNOTEK CO., LTD.) 17 February 2021 (2021-02-17)<br>See claims 1 and 8-10. | 1-10 |

☐ Further documents are listed in the continuation of Box C.　　☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **11 October 2022** | **11 October 2022** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

International application No.

**PCT/KR2022/010137**

| Patent document cited in search report | | | Publication date (day/month/year) | Patent family member(s) | | | Publication date (day/month/year) |
|---|---|---|---|---|---|---|---|
| KR | 10-2019-0042198 | A | 24 April 2019 | KR | 10-2310806 | B1 | 08 October 2021 |
| KR | 10-2020-0029874 | A | 19 March 2020 | CN | 112689906 | A | 20 April 2021 |
| | | | | US | 2021-0202819 | A1 | 01 July 2021 |
| | | | | WO | 2020-055100 | A1 | 19 March 2020 |
| KR | 10-2016-0047843 | A | 03 May 2016 | US | 2016-0118566 | A1 | 28 April 2016 |
| KR | 10-1716559 | B1 | 14 March 2017 | CN | 104335374 | A | 04 February 2015 |
| | | | | CN | 104335374 | B | 24 May 2017 |
| | | | | CN | 106876570 | A | 20 June 2017 |
| | | | | EP | 2858134 | A1 | 08 April 2015 |
| | | | | EP | 2858134 | A4 | 20 April 2016 |
| | | | | EP | 2858134 | A8 | 27 May 2015 |
| | | | | EP | 2858134 | B1 | 20 September 2017 |
| | | | | JP | 2014-007376 | A | 16 January 2014 |
| | | | | KR | 10-2015-0002865 | A | 07 January 2015 |
| | | | | US | 2015-0144171 | A1 | 28 May 2015 |
| | | | | US | 2017-0213953 | A1 | 27 July 2017 |
| | | | | US | 9680079 | B2 | 13 June 2017 |
| | | | | US | 9871181 | B2 | 16 January 2018 |
| | | | | WO | 2013-179840 | A1 | 05 December 2013 |
| KR | 10-2021-0017784 | A | 17 February 2021 | CN | 114207853 | A | 18 March 2022 |
| | | | | WO | 2021-029590 | A1 | 18 February 2021 |

Form PCT/ISA/210 (patent family annex) (July 2022)